# EUROPEAN PATENT SPECIFICATION

(11) **EP 0 840 452 B1**
(45) Date of publication and mention of the grant of the patent: **18.07.2001**
(21) Application number: 96830551.6
(22) Date of filing: 30.10.1996
(51) Int. Cl.: H03K 19/00, H03M 1/00, H03M 1/36, H03M 1/46, H03M 1/50

(54) **Voltage comparator including at least an insulated gate MOS transistor and analogic/digital converters using the same**
Spannungsvergleicher mit mindestens einem Isolierschicht-MOS-Transistor und damit ausgerüstete Analog-Digital-Wandler
Comparateur de tension comportant au moins un transistor MOS à grille isolée et des convertisseurs analogiques-numériques les utilisant

(43) Date of publication of application: 06.05.1998
(73) Proprietor: STMicroelectronics S.r.l., 20041 Agrate Brianza (Milano) (IT)
(72) Inventor: Kramer, Alan, c/o SGS-Thomson Microelectronics Srl, 20041 Agrate Brianza (MI) (IT); Canegallo, Roberto, 15057 Tortona (AL) (IT); Chinosi, Mauro, 20090 Cologno M.SE (MI) (IT); Gozzini, Giovanni, 25036 Palazzolo S/O (BG) (IT); Leong, Philip, c/o SGS-Thomson, 20041 Agrate Brianza (MI) (IT); Onorato, Marco, 116066 Genova (IT); Rolandi, Pier Luigi, 15053 Monleale (AL) (IT); Sabatini, Marco, c/o SGS-Thomson, 20041 Agrate Brianza (MI) (IT)
(74) Representative: Botti, Mario

(56) References cited:
- EP-A- 0 541 110
- US-A- 4 890 259
- US-A- 5 336 937
- US-A- 5 376 935
- PATENT ABSTRACTS OF JAPAN vol. 006, no. 081 (E-107), 19 May 1982 & JP 57 017223 A (TOSHIBA CORP), 28 January 1982,

## Description

This invention relates to a voltage comparator, and to analog-to-digital converters incorporating it.

Simple, easily integrated voltage comparators are known. US Patent 4,812,681 discloses a comparator formed of two cascade connected inverters of NMOS type. US Patents 5,237,326 and 5,451,952 respectively disclose two different comparators based on respective inverters of CMOS type, and two analog-to-digital converters of the flash type employing multiple comparators.

With all of the above comparators, an accurate setting of the threshold voltage is not readily achieved, since the threshold voltage is dependent on an external reference voltage and/or on the W/L ratii.

Another prior art solution is disclosed in the US patent No. 5,336,937 relating to an analog synapse circuit providing a single output current line which is a function of the input voltage and of weights stored in floating gate transistor.

A further prior art solution is disclosed in the US patent No. 5,376,935 relating to a digital-to-analog converter and to an analog to digital converter. The analog to digital converter includes inverter configurations with constent-on loads, a plurality of floating gate transistors each having a programmable threshold voltage.

Such a digital-to-analog converter substantially corresponds to the preamble of Claim 1.

It is the object of this invention to provide a comparator which is integratable in a simple and easy manner, and wherein the threshold voltage is easy to set accurately.

This object is achieved by a comparator having the characteristic features set forth in Claim 1, further advantageous aspects of this invention being set forth in the dependent claims.

By using, as the comparator element, an inverter comprised of at least two MOS transistors, of which only one is a floating gate type, the threshold voltage of the comparator can be readily set by "programming" the floating gate MOS transistor.

As is well known, floating gate MOS transistors are MOS transistors having, at their channel area location, beneath their gate terminal, an additional gate which is isolated from such gate and channel; the threshold voltage of these transistors is dependent on the amount of charge present on their floating gate. Several ways of programming such transistors, i.e. of injecting/extracting charge into/from their floating gates, are known from the literature. In view of the widespread application gained by these transistors in the field of semiconductor memory digital circuits, such as UV_EPROMs, EEPROMs, FLASH_EPROMs, the attention is directed to the abundant literature available on the subject for details on both their technological and circuit design aspects.

This invention further relates to analog-to-digital converters having the features set forth in Claim 5 or 7 and utilizing the inventive comparator, further advantageous aspects thereof being set forth in the dependent claims.

The invention can be better understood by having reference to the following description and its accompanying drawings, in which:
Figure 1 shows a comparator according to the invention;
Figure 2 shows two characteristics of respective comparators according to the invention;
Figure 3 shows an analog-to-digital converter of the flash type according to the invention; and
Figure 4 shows an analog-to-digital converter of the successive-approximation type according to the invention.

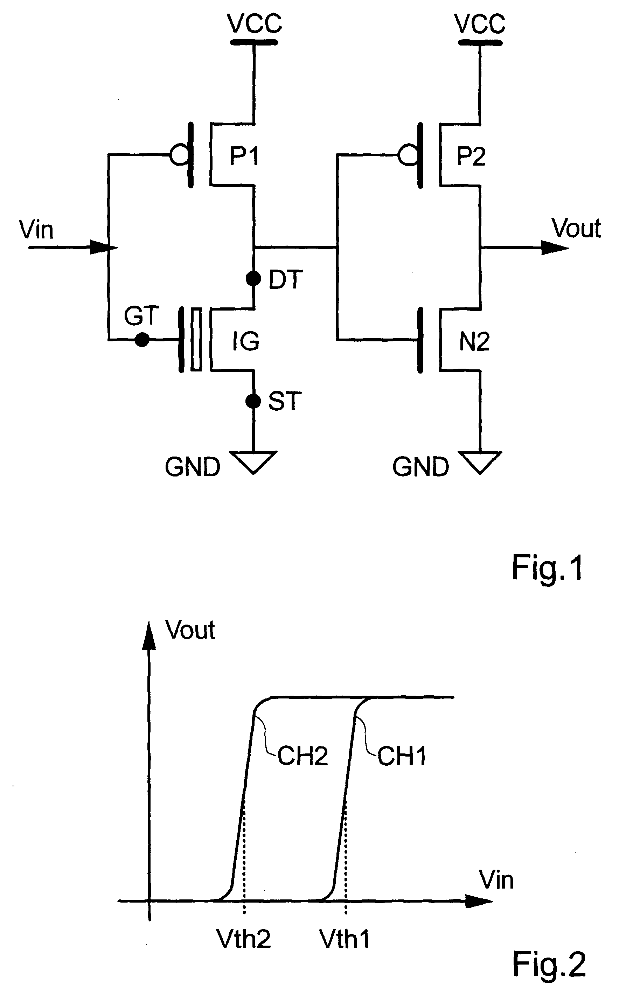

Referring to Figure 1, the voltage comparator of this invention has an analog signal input Vin and a digital signal output Vout, and includes an inverter, having an input coupled to the input Vin and an output coupled to the output Vout, which comprises at least two MOS transistors, P1 and IG, coupled to each other, of which at least one, e.g. the transistor IG, is of the floating gate type.

As is known, the threshold voltage of an inverter of either the NMOS or PMOS or CMOS type depends, inter alia, on the threshold voltages of the MOS transistors forming it, as well as on their W/L ratii. Thus, if at least one of the MOS transistors is of the floating gate type, the threshold voltage of the inverter can be controlled by controlling the threshold voltage of the transistor, i.e. by programming it.

Shown in Figure 2 are two different input/output characteristics CH1 and CH2 of the comparator in Figure 1, which correspond to two threshold voltage values of the transistor IG and have two different threshold voltages Vth1 and Vth2.

It is quite common for floating gate MOS transistors to be of the N-channel type, although they may also be of the P-channel type, as taught in Patent Applications EP 637073 and EP 730310.

In the comparator of Figure 1, the MOS transistor P1 is of the P-channel type and MOS transistor IG is of the floating gate N-channel type. Specifically for transistor P1, the gate terminal is connected to the input Vin, source terminal connected to the power supply VCC, and drain terminal connected to the inverter output; for transistor IG, the gate terminal GT is connected to the input Vin, drain terminal DT connected to the inverter output, and source terminal ST connected to a ground GND. Such an inverter is referred to as a CMOS type, and has virtually no current consumption.

All details pertaining to CMOS-type inverters can be found, for example, in a textbook "Digital CMOS Circuit Design" by M. Annaratone, Kluwer Academic Publishers, 1986, in particular under paragraphs 2.5 and 2.6.

Also, the comparator of Figure 1 includes an additional inverter, adapted to function as an output buffer, which is coupled between the output of the first inverter and the comparator output Vout. Specifically, this additional inverter comprises an N-channel MOS transistor N2 having its source terminal connected to a ground GND, gate terminal connected to the output of the first inverter, and drain terminal connected to the output Vout, and a P-channel MOS transistor P2 having its source terminal connected to the power supply VCC, gate terminal connected to the output of the first inverter, and drain terminal connected to the output Vout. In this way, greater freedom is allowed in the choice of the W/L ratii for the various MOS transistors; usually, in fact, the levels of the digital signal at the output Vout would be predetermined.

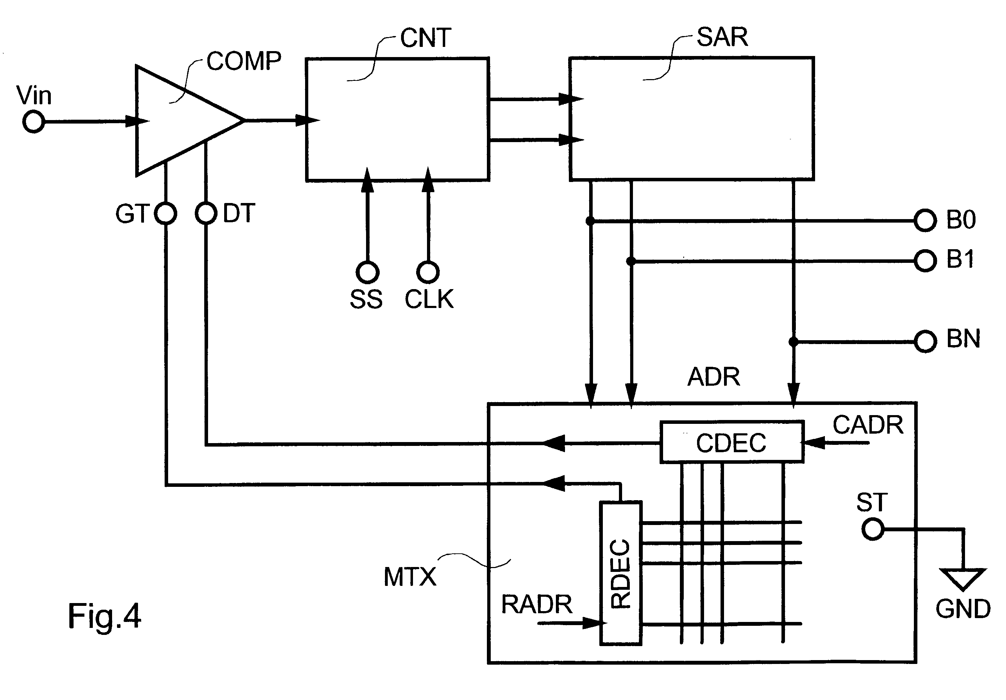

The comparator of this invention may comprise a plurality MTX of floating gate MOS transistors IG, preferably arranged in a matrix and being coupleable selectively and alternatively to the other MOS transistor P1 of the first inverter, as shown schematically in Figure 4. The advantage of this implementation will be explained more clearly hereinafter.

It can be advantageous if the comparator of this invention further includes programming circuitry for the floating gate MOS transistor(s), controllably operative to couple it(them) to predetermined programming potentials. In this way, full versatility can be obtained of the comparator.

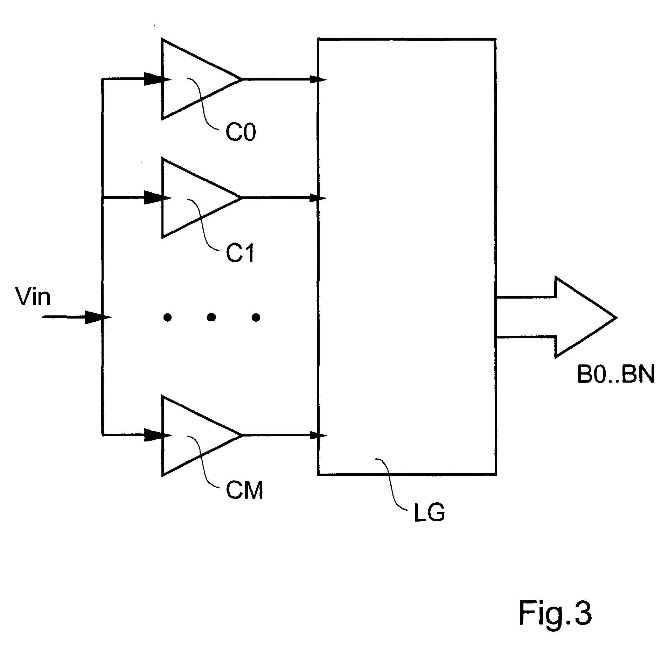

Referring to Figure 3, a first analog-to-digital converter according to the invention has an input Vin for an analog signal and a plurality of outputs B0,...,BN for digital signals, and comprises a plurality of comparators C0,...,CM, according to the invention, which have their inputs jointly coupled to the converter input Vin, and logic decode circuitry LG having inputs respectively coupled to the outputs of the comparators C0,...,CM, and having outputs coupled to converter outputs.

Understandably, the comparators C0,...,CM have different threshold voltages from one another, which are programmed once or during the converter operation.

If the number M of the comparators C0,...,CM equals two raised to a power of N, the index N being the number of the outputs B0,...,BN of the converter, then the outputs of the circuitry LG will be respectively connected to the outputs B0,...,BN. Such a converter is referred to as a flash type, and the conversion law will be determined by the values of the threshold voltages of the comparators C0,...,CM.

One analog-to-digital converter of the flash type is known from US Patent 5,237,326. A block diagram of this disclosure is shown in Figure 1, while Figure 2 shows a circuit diagram of the priority encoder which corresponds essentially to the circuitry LG.

Referring to Figure 4, a second analog-to-digital converter according to the invention has an input Vin for an analog signal and a plurality of outputs B0,...,BN for digital signals, and includes a comparator, according to the invention, which is of the type comprising a plurality of floating gate MOS transistors, having an input coupled to the converter input Vin, and logic control/encode circuitry, having an input coupled to the comparator output and outputs coupled to outputs of the converter and being adapted to select one of the plurality of MOS transistors for coupling.

Such a comparator may be formed, as shown in Figure 4, of a block COMP and a block MTX; the block COMP may correspond, for example, to the circuit shown in Figure 1, without the transistor IG, and has two terminals GT and DT respectively corresponding to the gate and drain terminals of the transistor IG. The block MTX may comprise a matrix of floating gate MOS transistors, a column decoder CDEC and a row decoder RDEC.

The block MTX includes an address input ADR consisting of plural lines for receiving an address signal which is effective to select one of the MOS transistors in the matrix. The matrix is represented schematically by a mesh of column and row lines; located at each intersection of one column line with one row line is a floating gate MOS transistor, not shown in the Figure, which has its drain terminal connected to the column line, gate terminal connected to the row line, and source terminal ST connected to the ground GND. The address lines are divided into two groups: a first group, for identifying a column address CADR, are connected to the inputs of the column decoder CDEC, and the second group, for identifying a row address RADR, are connected to the inputs of the row decoder RDEC. These decoders can connect only one of the respective lines to their respective outputs; thus, as an address is input to the block MTX, the block COMP will only be coupled to one floating gate MOS transistor in the matrix.

The logic control/encode circuitry can be implemented in more than one way.

This circuitry may be of the type intended for successive-approximation converters and comprise a control section CNT, being connected to the output of the comparator COMP amd having a clock input CLK and a start/stop input SS, as well as a register section SAR having inputs connected to outputs of the section CNT and having outputs connected both to the converter outputs B0,...,BN and to the input ADR lines; in this case, the circuitry would be operative to select the MOS transistors of the matrix by a binary search of some form.

One analog-to-digital converter of the successive-approximation type is disclosed in US Patent 5,247,299, whereof Figure 1 is a block diagram.

This circuitry is also useful with slope converters. In this case, the circuitry would be operative to select MOS transistors of the matrix with gradually increasing or decreasing threshold voltages, until the threshold voltage value of the comparator COMP exceeds the voltage value at the input Vin in either the positive or the negative direction.

## Claims

1. A voltage comparator comprising:
an input (Vin) for an analog signal and an output (Vout)
for a digital signal, and
a first inverter (P1,IG) which has an input coupled to the comparator input (Vin) and an output coupled to the comparator output (Vout), and
at least two MOS transistors (P1,IG) coupled to each other,
characterized in that said at least two MOS transistors (P1,IG) have the gate terminals connected to each other and to the comparator input and in that only one (IG) of the two MOS transistors is of the floating gate type; and
that a second inverter adapted to function as an output buffer is coupled between the output of the first inverter (P1,IG) and the output (Vout) of the comparator.

2. A comparator according to Claim 1, wherein one (P1) of the MOS transistors is of the P-channel type and the other (IG) is of the N-channel floating gate type.

3. A comparator according to one of the preceding claims, characterized in that said floating gate transistor (IG) is selected from a plurality (MTX) of floating gate MOS transistors (IG), preferably arranged into a matrix, which are selectively and alternatively coupleable to the other MOS transistor (P1) of the first inverter.

4. A comparator according to one of the preceding claims, further comprising programming circuitry for the floating gate MOS transistor and controllably adapted for coupling it(them) to predetermined programming potentials.

5. An analog-to-digital converter having an input (Vin) for an analog signal and a plurality of outputs (B0,...,BN) for digital signals, and comprising:
a) a plurality of comparators (C0,...,CM) as claimed in one of the preceding claims, having their inputs jointly coupled to the converter input (Vin); and
b) logic encode circuitry (LG) having inputs respectively coupled to the outputs of said comparators (C0,...,CM), and having outputs coupled to outputs of the converter.

6. A converter according to Claim 5, wherein the number (M) of said comparators (C0,...,CM) equals two raised to the power of the number (N) of the converter outputs (B0,...,BN).

7. An analog-to-digital converter having an input (Vin) for an analog signal and a plurality of outputs (B0,...,BN) for digital signals, and comprising:
a) a comparator (COMP,MTX) as claimed in either Claim 3 or 4, comprising a plurality (MTX) of floating gate MOS transistors and having an input coupled to the converter input (Vin); and
b) logic control/encode circuitry (CNT,SAR) having an input coupled to the output of said comparator (COMP) and having outputs coupled to converter outputs, which circuitry is operative to select one of said plurality (MTX) of MOS transistors for coupling.

8. A converter according to Claim 7 wherein said logic circuitry (CNT,SAR) is of the type intended for successive-approximation converters.

9. A converter according to Claim 7, wherein said logic circuitry (CNT,SAR) is of the type intended for slope converters.

## Patentansprüche

1. Spannungsvergleicher, umfassend:
einen Eingang (Vin) für ein Analogsignal und einen Ausgang (Vout) für ein Digitalsignal, und
einen ersten Negator (P1, IG), der mit einem Eingang an den Vergleichereingang (Vin) und mit einem Ausgang an den Vergleicherausgang (Vout) gekoppelt ist, und
mindestens zwei MOS-Transistoren (P1, IG), die miteinander gekoppelt sind,
dadurch gekennzeichnet, daß die mindestens zwei MOS-Transistoren (P1, IG) mit den Gate-Anschlüssen zusammengeschaltet und an den Vergleichereingang gekoppelt sind, und daß nur einer (IG) der beiden MOS-Transistoren vom Floating-Gate-Typ ist; und
daß ein zweiter Negator, ausgebildet zum Fungieren als Ausgangspuffer, zwischen den Ausgang des ersten Negators (P1, IG) und den Ausgang (Vout) des Vergleichers gekoppelt ist.

2. Vergleicher nach Anspruch 1, bei dem einer (P1) der MOS-Transistoren vom P-Kanal-Typ und der andere (IG) der N-Kanal-Transitor mit Floating-Gate ist.

3. Vergleicher nach einem der vorhergehenden Ansprüche, dadurch gekennzeichnet, daß der Transistor (IG) mit Floating-Gate ausgewählt ist aus einer Mehrzahl (MTX) von MOS-Transistoren (IG) mit Floating-Gate, vorzugsweise in einer Matrix angeordnet, die selektiv und alternativ an den anderen MOS-Transistor (P1) des ersten Negators koppelbar sind.

4. Vergleicher nach einem der vorhergehenden Ansprüche, weiterhin umfassend eine Programmierschaltung für den MOS-Transistor mit Floating-Gate und steuerbar ausgebildet für dessen (ihre) Ankopplung an vorbestimmte Programmierpotentiale.

5. Analog-Digital-Wandler mit einem Eingang (Vin) für ein Analogsignal und mit mehreren Ausgängen (B0, ... BN) für Digitalsignale, umfassend:
a) eine Mehrzahl von Vergleichern (CO, ... CM) nach einem der vorhergehenden Ansprüche, deren Eingänge gemeinsam an den Wandlereingang (Vin) gekoppelt sind; und
b) eine logische Codierschaltung (LG), die mit Eingängen an die Ausgänge der Vergleicher (C0, ... CM) gekoppelt sind und mit Ausgängen an Ausgänge des Wandlers gekoppelt sind.

6. Wandler nach Anspruch 5, bei dem die Anzahl (M) der Vergleicher (C0, ... CM) den Wert Zwei in der Potenz derjenigen Zahl (N) aufweist, in der Wandlerausgänge (B0, ... BN) vorhanden sind.

7. Analog-Digital-Wandler mit einem Eingang (Vin) für ein Analogsignal, und mit mehreren Ausgängen (B0, ... BN) für Digitalsignale, umfassend:
a) einen Vergleicher (COMP, MTX) nach Anspruch 3 oder 4, umfassend eine Mehrzahl (MTX) von MOS-Transistoren mit Floating-Gate, und mit einem Eingang an den Wandlereingang (Vin) angeschlossen; und
b) eine logische Steuer-/Codier-Schaltung (CNT, SAR), die mit einem Eingang an den Ausgang des Vergleichers (COMP) gekoppelt ist und mit Ausgängen an Wandlerausgänge gekoppelt ist, wobei die Schaltung so arbeitet, daß sie einen der mehreren (MTX) MOS-Transistoren für die Kopplung auswählt.

8. Wandler nach Anspruch 7, bei dem die logische Schaltung (CNT, SAR) vom Typ für Wandler mit sukzessiver Approximation ist.

9. Wandler nach Anspruch 7, bei dem die logische Schaltung (CNT, SAR) vom Typ für Slope-Wandler ist.

## Revendications

1. Comparateur de tension, comprenant :
une entrée (Vin) pour un signal analogique et une sortie (Vout) pour un signal numérique, et
un premier inverseur (P1, IG) dont une entrée est couplée à l'entrée (Vin) du comparateur et dont une sortie est couplée à la sortie (Vout) du comparateur, et
au moins deux transistors MOS (P1, IG) couplés entre eux,
caractérisé en ce que les bornes de grille desdits au moins deux transistors MOS (P1, IG) sont reliées entre elles et à l'entrée du comparateur et en ce que seul l'un (IG) des deux transistors MOS est du type à grille flottante ; et
en ce qu'un deuxième inverseur, conçu pour fonctionner comme tampon de sortie, est couplé entre la sortie du premier inverseur (P1, IG) et la sortie (Vout) du comparateur.

2. Comparateur selon la revendication 1, dans lequel l'un (P1) des transistors MOS est du type à canal P et l'autre (IG) est du type à grille flottante et à canal N.

3. Comparateur selon l'une des revendications précédentes, caractérisé en ce que ledit transistor à grille flottante (IG) est choisi parmi une pluralité (MTX) de transistors MOS à grille flottante (IG), de préférence agencés dans une matrice, pouvant être couplés de façon sélective et alternative à l'autre transistor MOS (P1) du premier inverseur.

4. Comparateur selon l'une quelconque des revendications précédentes, comprenant en outre des circuits de programmation du transistor MOS à grille flottante, conçus de façon à pouvoir être commandés, pour le(s) coupler à des potentiels de programmation prédéterminés.

5. Convertisseur analogique-numérique ayant une entrée (Vin) pour un signal analogique et une pluralité de sorties (BO, ..., BN) pour des signaux numériques, et comprenant :
a) une pluralité de comparateurs (CO, ..., CM), selon l'une quelconque des revendications précédentes, dont les entrées sont conjointement couplées à l'entrée (Vin) du convertisseur ; et
b) des circuits de codage logique (LG) dont les entrées sont respectivement couplées aux sorties desdits comparateurs (CO, ..., CM) et dont les sorties sont couplées aux sorties du convertisseur.

6. Convertisseur selon la revendication 5, dans lequel le nombre (M) desdits comparateurs (CO, ..., CM) est égal à deux à la puissance du nombre (N) de sorties (BO, ... BN) du convertisseur.

7. Convertisseur analogique-numérique ayant une entrée (Vin) pour un signal analogique et une pluralité de sorties (B0, ..., BN) pour les signaux numériques, et comprenant :
a) un comparateur (COMP, MTX) selon l'une des revendications 3 ou 4, comprenant une pluralité (MTX) de transistors MOS à grille flottante et dont une entrée est couplée à l'entrée (Vin) du convertisseur ; et
b) des circuits de codage/commande logique (CNT, SAR) dont une entrée est couplée à la sortie dudit comparateur (COMP) et dont les sorties sont couplées aux sorties du convertisseur, lesdits circuits pouvant choisir l'un des transistors MOS de ladite pluralité (MTX) de transistors MOS pour le couplage.

8. Convertisseur selon la revendication 7, dans lequel lesdits circuits logiques (CNT, SAR) sont du type prévu pour les convertisseurs d'approximations successives.

9. Convertisseur selon la revendication 7, dans lequel lesdits circuits logiques (CNT, SAR) sont du type prévu pour les convertisseurs de pente.
